# EUROPÄISCHE PATENTSCHRIFT

(11) **EP 2 126 991 B1**
(45) Veröffentlichungstag und Bekanntmachung des Hinweises auf die Patenterteilung: **12.10.2011**
(21) Anmeldenummer: 07857871.3
(22) Anmeldetag: 19.12.2007
(51) Int. Cl.: H01L 41/04, H01L 41/24, H01L 41/083

(54) **PIEZOKERAMISCHER VIELSCHICHTAKTOR UND VERFAHREN ZU SEINER HERSTELLUNG**
PIEZOCERAMIC MULTILAYER ACTUATOR AND METHOD FOR PRODUCING IT
ACTIVATEUR MULTICOUCHE PIÉZOCÉRAMIQUE ET SON PROCÉDÉ DE FABRICATION

(30) Priorität: 29.12.2006 DE 102006062076
(43) Veröffentlichungstag der Anmeldung: 02.12.2009
(73) Patentinhaber: Siemens Aktiengesellschaft, 80333 München (DE)
(72) Erfinder: KASTL, Harald Johannes, 95686 Fichtelberg (DE); REICHINGER, Christian, 93073 Neutraubling (DE); SCHUH, Carsten, 85598 Baldham (DE)
(86) Internationale Anmeldenummer: PCT/EP2007/064250
(87) Internationale Veröffentlichungsnummer: WO 2008/080859

(56) Entgegenhaltungen:
- EP-A- 0 485 995
- DE-A1- 4 201 937
- DE-A1- 10 307 825

## Beschreibung

Die vorliegende Erfindung betrifft einen piezokeramischen Vielschichtaktoren und ein Verfahren zu seiner Herstellung.

Piezokeramische Vielschichtaktoren, die auch als Multilayer-Stacks bezeichnet werden, sind gestapelte Schichtstrukturen, die abwechselnd Schichten aus Piezokeramik und Innenelektrodenmaterial aufweisen. Die Innenelektroden reichen in dieser Konstruktion bis zu den Seitenflächen des Vielschichtaktors, um ein größtmögliches aktives Volumen in den piezokeramischen Schichten pro Bauvolumen des Vielschichtaktors zu erzielen.

Derartige piezokeramische Vielschichtaktoren sind beispielsweise aus DE 42 01 947 A1 und aus DE 103 07 825A1 bekannt. Die bekannten piezokeramischen Vielschichtaktoren weisen Entlastungszonen auf, innerhalb derer mechanische Spannungen im piezokeramischen Vielschichtaktor reduzierbar sind.

Reichen die Innenelektroden jedoch bis an die Außenseiten des Vielschichtaktors, können derart konstruierte Vielschichtaktoren nicht direkt in elektrisch leitenden Flüssigkeiten oder Gasen betrieben werden. Diese Flüssigkeiten oder Gase würden zu einem elektrischen Kurzschluss der verschiedenen Innenelektroden und somit zum Versagen des Vielschichtaktors führen. Dies ist gerade von Nachteil, wenn die piezokeramischen Vielschichtaktoren in Kraftstoffen von Brennkraftmaschinen, wie zum Beispiel in Direkteinspritzsystemen im Automobilbereich, eingesetzt werden. Diese Kraftstoffe enthalten üblicherweise gewisse Anteile an Wasser oder Additiven, die einen elektrischen Kurzschluss zwischen bis an die Außenseite ragenden Innenelektroden erzeugen würden. Der gleiche Nachteil ergibt sich beim Einsatz in einer Umgebung mit hoher Luftfeuchtigkeit, beispielsweise bei der Verwendung des Vielschichtaktors in Pneumatikventilen oder als Mass-Flow-Controller. Daher ist eine elektrische Passivierung oder Isolation des piezokeramischen Vielschichtaktors gegenüber dem ihn umgebenden Medium zwingend erforderlich.

Das Material zur Passivierung des Vielschichtaktors muss jedoch ein ähnliches Dehnungsvermögen wie der Vielschichtaktor selbst aufweisen. Die erzielbare homogene Dehnung des Vielschichtaktors beträgt bis zu 0,2 % seiner Länge. Treten im piezokeramischen Vielschichtaktor jedoch in bestimmten Bereichen Polungsrisse auf, beispielsweise in inaktiven Kontaktierungszonen, werden in diesen Bereichen wesentlich höhere relative Dehnungen des Vielschichtaktors verglichen mit seiner homogenen Dehnung erzielt. Daher müsste ein zur Passivierung des Vielschichtaktors eingesetztes Beschichtungsmaterial üblicherweise eine zyklische mechanische Dauerdehnbarkeit in der Größenordnung von mehr als 10 % aufweisen. Wird eine derartige Passivierung beispielsweise in einem Direkteinspritzsystem im Automobilbereich genutzt, ist von diesem Material gleichzeitig eine Temperaturstabilität bis ca. 180° C gefordert. Diese Materialanforderungen erfüllen nur Silikonelastomere, die jedoch eine unzureichende Beständigkeit in Kraftstoffen sowie eine hohe Permeabilität für Wasserdampf zeigen.

Eine im Stand der Technik eingesetzte Lösung zum Schutz des piezokeramischen Vielschichtaktors nutzt eine Kapselung desselbigen gegenüber seiner Umgebung. Diese Kapselung besteht aus einem hermetisch dichten metallischen Gehäuse, das die Nutzdehnung des piezokeramischen Vielschichtaktors nicht behindert. Diese Kapselung wird auch als Dehn- oder Wellrohr bezeichnet. Diese Kapselungslösungen sind jedoch kostspielig und zudem für erhöhte Umgebungsdrücke bisher nicht realisierbar.

Es ist daher die Aufgabe der vorliegenden Erfindung, einen piezokeramischen Vielschichtaktor und ein Verfahren zu seiner Herstellung bereitzustellen, der in Kraftstoffen von Brennkraftmaschinen auch unter hohem Druck sowie unter anderen für piezokeramische Vielschichtaktoren ungünstigen Umgebungsbedingungen, beispielsweise hohe Luftfeuchtigkeit, einsetzbar ist.

Die obige Aufgabe wird durch einen piezokeramischen Vielschichtaktor gemäß dem unabhängigen Patentanspruch 1 und durch ein Verfahren zu seiner Herstellung gemäß dem unabhängigen Patentanspruch 9 gelöst. Vorteilhafte Ausgestaltungen und Weiterentwicklungen der vorliegenden Erfindung gehen aus der folgenden Beschreibung, den Zeichnungen und den anhängenden Patentansprüchen hervor.

Der piezokeramische Vielschichtaktor weist die folgenden Merkmale auf: eine Mehrzahl piezokeramischer Schichten und eine Mehrzahl von Elektroden, die in einer Stapelrichtung übereinander angeordnet sind, so dass sich die Elektroden an gegenüberliegenden Seiten der piezokeramischen Schichten befinden, mindestens eine mikromechanische Entlastungszone, innerhalb derer mechanische Spannungen im piezokeramischen Vielschichtaktor reduzierbar sind, während eine Mehrzahl von Abschnitten des piezokeramischen Vielschichtaktors ohne mikromechanische Entlastungszone eine Isolationsschicht aufweisen, so dass der jeweilige Abschnitt des piezokeramischen Vielschichtaktors gegen ein den piezokeramischen Vielschichtaktor umgebendes Medium elektrisch, chemisch und/oder thermisch isoliert ist, und die Isolationsschicht sich nur über Abschnitte des piezokeramischen Vielschichtaktors ohne mikromechanischen Entlastungszone erstreckt.

Die Grundlage der vorliegenden Erfindung bildet ein piezokeramischer Vielschichtaktor mit intrinsischen Sicherheitsstrukturen, die hier als Entlastungszonen bezeichnet sind. Diese Entlastungszonen werden durch keramische Schichten oder Elektroden gebildet, die einen örtlichen Bereich für das Auftreten von Polungsrissen im piezokeramischen Vielschichtaktor vorgeben. Dies bedeutet, dass Polungsrisse während des Betriebs des Vielschichtaktors nur in den vorgegebenen Bereichen dieser mikromechanischen Entlastungszonen auftreten. In den benachbart zu diesen mikromechanischen Entlastungszonen angeordneten Abschnitten des piezokeramischen Vielschichtaktors ohne Entlastungszone treten keine Polungsrisse auf, so dass bei einer elektrischen Ansteuerung des piezokeramischen Vielschichtaktors die homogene Dehnung von ca. 0,2 % in diesen Abschnitten nicht überschritten wird. Da die mikromechanische Entlastungszonen nur als mechanische Strukturkomponente ausgebildet sind und keine elektrische Funktion im piezokeramischen Vielschichtaktor erfüllen, wird durch die auftretenden Polungsrisse in diesen Entlastungszonen die elektrische Funktionstüchtigkeit des Vielschichtaktors nicht beeinträchtigt, auch wenn in diesen Bereichen keine Isolationsschicht aufgebracht ist.

Aufgrund der oben beschriebenen Konstruktion ist es daher möglich, auf die Abschnitte ohne mikromechanische Entlastungszone eine Isolationsschicht aus Glas, Keramik oder einem sinterbaren Material aufzubringen, deren Dehnungsfähigkeit der homogenen Dehnung des piezokeramischen Vielschichtaktors und/oder deren thermischer Ausdehnungskoeffizient annähernd dem des Vielschichtaktors entspricht. Da die mikromechanischen Entlastungszonen innerhalb des Vielschichtaktors Dehnungsbelastungen oberhalb der homogenen Dehnung des Vielschichtaktors von der Isolationsschicht fernhalten, da diese nur in den Abschnitten ohne mikromechanische Entlastungszone aufgebracht ist, sind daher Materialien als Isolationsschicht nutzbar, die bisher aufgrund der auftretenden Polungsrisse und der entsprechend hohen Dehnung nicht genutzt werden konnten. Neben der Verwendung von Glas und/oder Keramik zur Herstellung der Isolationsschicht ist es ebenfalls denkbar, Kunststoffe oder Polymere zur Isolation zu verwenden.

Gemäß einer bevorzugten Ausführungsform der vorliegenden Erfindung wird die Isolationsschicht nicht durch ein auf die Außenseite des piezokeramischen Vielschichtaktor zusätzlich aufzubringendes Material hergestellt. Stattdessen werden parallel zur Stapelrichtung des piezokeramischen Vielschichtaktors und angrenzend an ein umgebendes Medium piezoelektrisch inaktive Bereiche im Vielschichtaktor erzeugt, die die Isolationsschicht bilden. Dieser piezoelektrisch inaktive Bereich, der auch als piezoelektrisch inaktiver Randbereich bezeichnet wird, entsteht aufgrund der Verwendung von Elektroden innerhalb der Konstruktion des piezokeramischen Vielschichtaktors, die in ihrer Fläche jeweils kleiner ausgebildet sind als die angrenzenden piezokeramischen Schichten. Da die mikromechanischen Entlastungszonen die mechanischen Spannungen innerhalb des Vielschichtaktors abbauen, werden diese piezoelektrisch inaktiven Randbereiche nicht durch Polungsrisse zerstört, so dass sie die Funktion einer Isolationsschicht gegen umgebende Medien erfüllen.

Das Herstellungsverfahren für den oben beschriebenen piezokeramischen Vielschichtaktor weist die folgenden Schritte auf: Bereitstellen einer Mehrzahl piezokeramischer Grünfolien und Aufbringen von Elektroden auf zumindest eine Seite der piezokeramischen Grünfolie, Anordnen der piezokeramischen Grünfolie mit Elektroden in einer Stapelrichtung übereinander zu einem Stapel und Sintern des Stapels, während innerhalb des Stapels mindestens eine Materialschicht angeordnet ist, die nach dem Sintern eine mikromechanische Entlastungszone bildet, und Herstellen einer Isolationsschicht angrenzend an ein den piezokeramischen Vielschichtaktor umgebendes Medium in Abschnitten des piezokeramischen Vielschichtaktors ohne mikromechanische Entlastungszone, so dass der piezokeramische Vielschichtaktor nach außen elektrisch, chemisch und/oder thermisch isoliert ist.

Die vorliegende Erfindung wird unter Bezugnahme auf die begleitende Zeichnung näher erläutert. Es zeigen:
- Fig. 1: eine schematische Darstellung eines piezokeramischen Vielschichtaktors mit an der Außenseite des Vielschichtaktors aufgebrachter Isolationsschicht,
- Fig. 2A: eine schematische Darstellung eines piezokeramischen Vielschichtaktors mit piezoelektrisch inaktiven Randbereichen als Isolationsschicht,
- Fig. 2B: einen Schnitt durch einen piezokeramischen Vielschichtaktor mit piezoelektrisch inaktiven Randbereichen senkrecht zur Stapelrichtung und
- Fig. 3: ein Flussdiagramm zur Beschreibung bevorzugter Herstellungsverfahren des erfindungsgemäßen piezokeramischen Vielschichtaktors.

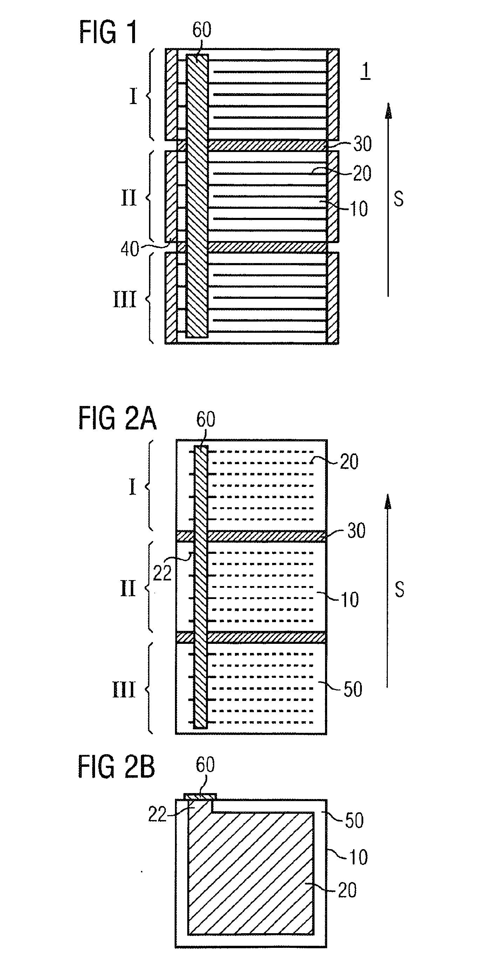

Die vorliegende Erfindung offenbart einen piezokeramischen Vielschichtaktor 1, der gemäß zwei verschiedener Ausführungsformen in den Figuren 1 und 2 dargestellt ist. Der piezokeramische Vielschichtaktor 1 besteht aus einer alternierenden Anordnung einer Mehrzahl von piezokeramischen Schichten 10 und einer Mehrzahl von Elektroden 20. Diese sind in Stapelrichtung S übereinander angeordnet.

Gemäß der in Fig. 1 dargestellten Ausführungsform sind die Elektroden 20 in Bezug auf die angrenzenden piezokeramischen Schichten 10 vollflächig ausgebildet. Ausgenommen eines Bereichs nahe einer Außenelektrode 60 erstrecken sich somit die Elektroden 20 über die gesamte Fläche der angrenzenden piezokeramischen Schichten 10.

Der piezokeramische Vielschichtaktor ist in unterschiedliche Abschnitte I, II, III oder Substacks unterteilt, während die Grenzfläche benachbarter Abschnitte I, II, III durch eine mikromechanische Entlastungszone gebildet wird. Die mikromechanische Entlastungszone 30 erstreckt sich über den gesamten Querschnitt des piezokeramischen Vielschichtaktors 1. Sie ist derart ausgebildet, dass sie mechanische Spannungen innerhalb des piezokeramischen Vielschichtaktors 1 aufnimmt und entlastet, da diese andernfalls zur Ausbildung von schädigenden Rissen in den Abschnitten I, II, III des piezokeramischen Vielschichtaktors 1 führen würden. Mechanische Spannungen dieser Größenordnung treten beispielsweise beim Polen des piezokeramischen Vielschichtaktors 1 auf, wodurch Polungsrisse ausgebildet werden. Durch den Einsatz der mikromechanischen Entlastungszonen 30 entstehen die Polungsrisse nicht innerhalb der Abschnitte I, II, III des piezokeramischen Vielschichtaktors 1, so dass die Funktionsfähigkeit des piezokeramischen Vielschichtaktors 1 nicht beeinträchtigt ist.

Gemäß einer Ausführungsform bestehen die mikromechanischen Entlastungszonen 30 aus einer porösen elektrisch nicht leitenden Keramikschicht, wie es in DE 102 34 787 C1 beschrieben ist. Das Gefüge dieser porösen Keramikschicht stellt eine verringerte Zugfestigkeit im Vergleich zu den Abschnitten I, II, III des piezokeramischen Vielschichtaktors 1 parallel zur Stapelrichtung S bereit, die Risswachstum in der mikromechanischen Entlastungszone 30 begünstigt. Gemäß einer weiteren Alternative wird die mikromechanische Entlastungszone 30, die man auch als Sollbruchstelle bezeichnet, durch eine Elektrodenschicht gebildet. Aufgrund ihrer Zusammensetzung delaminiert diese Elektrodenschicht bei kritischen Zugspannungen parallel zur Stapelrichtung S innerhalb des piezokeramischen Vielschichtaktors 1. Dies ist in DE 10 2004 031 402 A1 beschrieben.

Durch den Einsatz der mikromechanischen Entlastungszonen 30 werden Polungsrisse beim Betrieb des piezokeramischen Vielschichtaktors 1 nur in den vorgegebenen Bereichen dieser Entlastungszonen 30 gebildet. Da die in den Entlastungszonen 30 gebildeten Polungsrisse nicht durch ein elektrisches Feld belastet sind - eine Entlastungszone 30 stellt einen Bereich gleichen elektrischen Potentials dar - und es hier zu keiner Verzweigung von Rissen in Richtung der Stapelrichtung S kommt, das heißt in Richtung Innenelektroden unterschiedlichen elektrischen Potentials, ist ein Eindringen von elektrisch leitfähigen Flüssigkeiten oder Gasen unkritisch für Funktion und Lebensdauer des piezokeramischen Vielschichtaktors 1.

In den zu den mikromechanischen Entlastungszonen 30 benachbarten Abschnitten I, II, III des piezokeramischen Vielschichtaktors 1 entstehen keine Polungsrisse, so dass beim Betrieb des piezokeramischen Vielschichtaktors 1 die auftretende homogene Dehnung von ca. 0,2 % in diesen Abschnitten I, II, III im Kontaktierungs- und Oberflächenbereich nicht überschritten wird. Auf dieser konstruktiven Grundlage wird in den Abschnitten I, II, III eine Isolationsschicht 40; 50 erzeugt, die den piezokeramischen Vielschichtaktor 1 gegen ein umgebendes Medium elektrisch, chemisch und/oder thermisch isoliert. Diese Isolationsschicht 40, 50 muss nur ein Dehnungsvermögen im Bereich der homogenen und dynamischen Dehnung des piezokeramischen Vielschichtaktors 1 ohne Versagen aufweisen. Zudem ist es bevorzugt, dass die Isolationsschicht 40, 50 einen thermischen Ausdehnungskoeffizienten in der Größenordnung des thermischen Ausdehnungskoeffizienten des Vielschichtaktors 1 aufweist.

Die Isolationsschicht 40 besteht gemäß der ersten Ausführungsform des piezokeramischen Vielschichtaktors 1 aus einer auf die elektrisch aktive Oberfläche des piezokeramischen Vielschichtaktors 1 aufgebrachten dünnen polymeren, glasartigen oder keramischen Passivierungsschicht. Diese gewährleistet die elektrische Isolation des piezokeramischen Vielschichtaktors 1 gegenüber der Umgebung, erträgt bei Polung und während des Betriebs des piezokeramischen Vielschichtaktors 1 auftretende homogene reversible und dynamische Dehnungen ohne Zerstörung im Bereich von bis zu ca. 0,5 % und sie zeigt eine verlässliche Haftung auf der Oberfläche des piezokeramischen Vielschichtaktors 10 ohne Delamination.

Es ist zudem bevorzugt, das Aufbringen der Isolationsschicht 40 parallel zu bekannten Herstellungsschritten des piezokeramischen Vielschichtaktors 1 durchzuführen. So wird beispielsweise vor dem Sintern des Grünkörpers des piezokeramischen Vielschichtaktors 1 eine keramische Isolationsschicht 40 auf der Außenseite des jeweiligen Abschnitts I, II, III oder des gesamten piezokeramischen Vielschichtaktors 1 aufgebracht und während des Sinterns erzeugt.

Gemäß weiterer Alternativen besteht die Isolationsschicht 40 aus Kunststoff oder einem Polymer. Es ist zudem bevorzugt, hier mechanisch stabile Kunststoffe oder Polymere einzusetzen, die ein ähnliches Dehnungsvermögen wie die Abschnitte I, II, III ohne Polungsrisse aufweisen.

Fig. 2 zeigt eine weitere Ausführungsform des piezokeramischen Vielschichtaktors 1. Die mit den in Fig. 1 dargestellten funktionell identischen Komponenten des piezokeramischen Vielschichtaktors 1 sind in Fig. 2 mit den gleichen Bezugszeichen gekennzeichnet. Im Unterschied zur Ausführungsform gemäß Fig. 1 wird die Isolationsschicht 50 in Fig. 2 durch eine geeignete Wahl des Flächeninhalts der Elektroden 20 im Vergleich zum Flächeninhalt der benachbarten piezokeramischen Schichten 10 erzeugt. Wie in den Figuren 2A und 2B dargestellt ist, weist die Elektrode 20 einen kleineren Flächeninhalt als die benachbarte piezokeramische Schicht 10 auf. Auf diese Weise wird im Umfangsbereich des piezokeramischen Vielschichtaktors 1 parallel zur Stapelrichtung S ein inaktiver Bereich ausgebildet, der den piezokeramischen Vielschichtaktor 1 gegen das umgebende Medium isoliert und abschirmt. Da sich Polungsrisse nur in den mikromechanischen Entlastungszonen 30 ausbilden, liefert die piezoelektrisch inaktive Isolationsschicht 50 eine geschlossene "Umhüllung" des piezoelektrisch aktiven Bereichs des Vielschichtaktors 1.

Die Elektroden 20 weisen einen Kontaktierungsabschnitt 22 auf, der an die Außenseite des piezokeramischen Vielschichtaktors 1 führt (vgl. Fig. 2B). Dort wird der Kontaktierungsabschnitt 22 mit einer Außenelektrode 60 verbunden, um den piezokeramischen Vielschichtaktor 1 elektrisch ansteuern zu können.

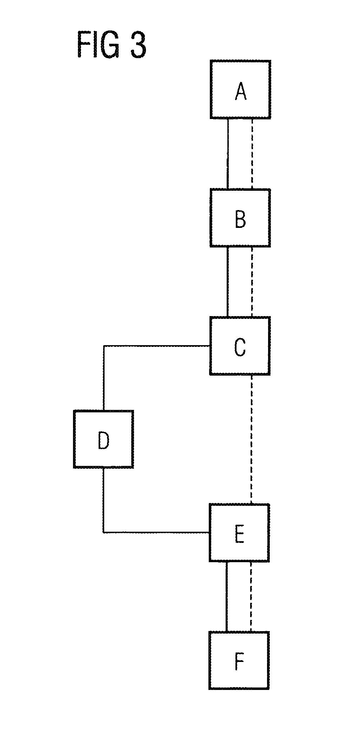

Mögliche Herstellungsverfahren für den piezokeramischen Vielschichtaktor 1 sind schematisch in Fig. 3 dargestellt. Gemäß einer ersten Verfahrensalternative werden die Schritte ausgeführt, die über eine durchgezogene Linie miteinander verbunden sind. Zunächst wird im Schritt A eine Mehrzahl piezokeramischer Grünfolien bereitgestellt, auf die nachfolgend im Schritt B Elektroden auf zumindest eine Seite aufgebracht werden. Danach werden im Schritt C piezokeramische Grünfolien mit Elektroden in einer Stapelrichtung S übereinander zu einem Stapel angeordnet. Dieser Stapel umfasst zudem mindestens eine Materialschicht, die nach dem Sintern eine mikromechanische Entlastungszone 30 bildet. Vor dem Sintern (Schritt E) des Stapels werden die Außenseiten des Stapels parallel zur Stapelrichtung S nur innerhalb der späteren Abschnitte I, II, III mit einer Schicht aus keramikähnlichem Material, vorzugsweise Glas, Keramik, beschichtet (Schritt C). Das Material für diese Beschichtung ist derart ausgewählt, dass es ein mit dem piezokeramischen Vielschichtaktor 1 annähernd übereinstimmendes Dehnungsvermögen aufweist. Danach wird der Stapel im Schritt E gesintert.

Es ist ebenfalls bevorzugt, die Isolationsschicht 40 nach dem Sintern (E) aufzubringen und mit einer geeigneten Wärmebehandlung einzubrennen (Schritt F). Dieser Verfahrensweg ist in Fig. 3 durch eine gestrichelte Linie dargestellt. Für den Schritt F ist es des Weiteren denkbar, den gesinterten Vielschichtaktor mit Kunststoff oder einem Polymer zu beschichten, um die Isolationsschicht 40 zu bilden. Für die Materialien der Isolationsschicht ist es ausreichend, wenn sie ein Dehnungsvermögen von ca. 0,5 % aufweisen, um den Bewegungen der Abschnitte I, II, III des Vielschichtaktors 1 ohne Schädigung folgen zu können. Es ist des Weiteren vorteilhaft, wenn sie einen geringeren Elastizitätsmodul als Vielschichtaktor und/oder einen annähernd übereinstimmenden thermischen Ausdehnungskoeffizienten wie der Vielschichtaktor aufweisen. Zur Herstellung des piezokeramischen Vielschichtaktors 1 gemäß der Ausführungsform in Fig. 2A werden bereits im Schritt B Elektroden 20 auf Grünfolien aufgebracht, beispielsweise aufgedruckt, deren Flächeninhalt kleiner als der der späteren angrenzenden piezokeramischen Schicht 10 ist. Fügt man diese piezokeramischen Schichten und Elektroden zu einem Stapel zusammen, entsteht mit dem Sintern (E) der piezoelektrisch inaktive Randbereich, der die Isolationsschicht 50 bildet.

## Patentansprüche

1. Piezokeramischer Vielschichtaktor (1), der die folgenden Merkmale aufweist:
a. eine Mehrzahl piezokeramischer Schichten (10) und eine Mehrzahl von Elektroden (20), die in einer Stapelrichtung (S) übereinander angeordnet sind, so dass sich die Elektroden (20) an gegenüberliegenden Seiten der piezokeramischen Schichten (10) befinden,
b. mindestens eine mikromechanische Entlastungszone (30), innerhalb derer mechanische Spannungen im piezokeramischen Vielschichtaktor (1) reduzierbar sind, während
c. eine Mehrzahl von Abschnitten (I, II, III) des piezokeramischen Vielschichtaktors (1) ohne mikromechanische Entlastungszone (30) eine Isolationsschicht (40; 50) aufweist, so dass der Abschnitt (I, II, III) des piezokeramischen Vielschichtaktors (1) gegen ein den piezokeramischen Vielschichtaktor (1) umgebendes Medium elektrisch, chemisch und/oder thermisch isoliert ist,
wobei
sich die Isolationsschicht (40; 50) nur über Abschnitte (I, II, III) des piezokeramischen Vielschichtaktors (1) ohne mikromechanische Entlastungszone (30) erstreckt.

2. Piezokeramischer Vielschichtaktor (1)gemäß Anspruch 1, in dem die Isolationsschicht (40) eine Passivierungsschicht ist, die vor einem Sintervorgang eines Vielschichtaktor-Grünkörpers oder einer Wärmebehandlung des piezokeramischen Vielschichtaktors (1) aufbringbar ist.

3. Piezokeramischer Vielschichtaktor (1) gemäß Anspruch 3, dessen Isolationsschicht (40) aus Glas, Keramik oder einem sinterbaren Material besteht, deren Dehnungsfähigkeit und /oder thermischer Ausdehnungskoeffizient annähernd der/dem des piezokeramischen Vielschichtaktors (1) entspricht.

4. Piezokeramischer Vielschichtaktor (1) gemäß Anspruch 1, in dem die Isolationsschicht (40) eine Passivierungsschicht ist, die nach einem Sintervorgang des piezokeramischen Vielschichtaktors (1) aufbringbar ist.

5. Piezokeramischer Vielschichtaktor (1) gemäß Anspruch 4, dessen Isolationsschicht (40) aus einem Kunststoff oder Polymer besteht.

6. Piezokeramischer Vielschichtaktor (1) gemäß Anspruch 1, der angrenzend an ein umgebendes Medium einen piezoelektrisch inaktiven Bereich (50) aufweist, der die Isolationsschicht bildet.

7. Piezokeramischer Vielschichtaktor (1) gemäß Anspruch 6, in dem die Elektroden in ihrer Fläche jeweils kleiner ausgebildet sind als die piezokeramischen Schichten, so dass die piezokeramischen Schichten jeweils einen piezoelektrisch inaktiven Randbereich aufweisen.

8. Piezokeramisches Bauteil gemäß Anspruch 6 oder 7, dessen Elektroden (20) jeweils einen Kontaktierungsabschnitt (22) aufweisen, der bis an einen äußeren Rand einer piezokeramischen Schicht (10) reicht, so dass die Elektroden (20) von einer Außenseite des piezokeramischen Vielschichtaktors (1) elektrisch kontaktierbar sind.

9. Herstellungsverfahren für einen piezokeramischen Vielschichtaktor (1) nach einem der Ansprüche 1 bis 7, das die folgenden Schritte aufweist:
a. Bereitstellen (A) einer Mehrzahl piezokeramischer Grünfolien und Aufbringen (B) von Elektroden auf zumindest eine Seite der piezokeramischen Grünfolie,
b. Anordnen (C) der piezokeramischen Grünfolien mit Elektroden in einer Stapelrichtung (S) übereinander zu einem Stapel und Sintern (E) des Stapels, während innerhalb des Stapels mindestens eine Materialschicht angeordnet ist, die nach dem Sintern eine mikromechanische Entlastungszone (30) bildet, und
c. Herstellen (D; F) einer Isolationsschicht (40; 50) angrenzend an ein den piezokeramischen Vielschichtaktor (1) umgebendes Medium in Abschnitten (I, II, III) des piezokeramischen Vielschichtaktors (1) ohne mikromechanische Entlastungszone (30), so dass der piezokeramische Vielschichtaktor (1) nach außen elektrisch, chemisch und/oder thermisch isoliert ist.

10. Herstellungsverfahren gemäß Anspruch 9, in dem nach dem Sintern in einem Abschnitt (I, II, III) des piezokeramischen Vielschichtaktors (1), der keine mikromechanische Entlastungszone (30) enthält, eine Isolationsschicht (40) auf eine äußere Fläche des piezokeramischen Vielschichtaktors (1) parallel zur Stapelrichtung (S) aufgebracht wird (F).

11. Herstellungsverfahren gemäß Anspruch 10, dessen Passivierungsschicht (40) aus Kunststoff oder einem Polymer besteht.

12. Herstellungsverfahren gemäß Anspruch 11, in dem vor dem Sintern in einem Abschnitt (I, II, III) des piezokeramischen Vielschichtaktors (1), der nach dem Sintern keine mikromechanische Entlastungszone (30) enthält, eine Schicht, insbesondere eine Keramik ähnliche Schicht, auf eine äußere Fläche des piezokeramischen Vielschichtaktors (1) parallel zur Stapelrichtung (S) aufgebracht wird (D), aus der während des Sinterns oder einer Wärmebehandlung des piezokeramischen Vielschichtaktors (1) eine Passivierungsschicht (40) gebildet wird.

13. Herstellungsverfahren gemäß Anspruch 12, dessen Passivierungsschicht (40) aus Glas, Keramik oder einem Material besteht, das ein mit dem piezokeramischen Vielschichtaktor (1) annähernd übereinstimmendes Dehnungsvermögen und/oder thermischen Ausdehnungskoeffizienten aufweist.

14. Herstellungsverfahren gemäß Anspruch 9, in dem die Isolationsschicht (50) durch Bilden inaktiver Bereiche in einem Umfangsbereich des piezokeramischen Vielschichtaktors (1) parallel zur Stapelrichtung (S) derart gebildet wird, dass eine Fläche der Elektroden (20) in Bezug auf eine Fläche der angrenzenden piezokeramischen Grünfolien kleiner ausgebildet sind.

## Claims

1. Piezoceramic multilayer actuator (1) having the following features:
a. a number of piezoceramic layers (10) and a number of electrodes (20), which are disposed one above the other in a stacking direction (S), so that the electrodes (20) are located on opposing sides of the piezoceramic layers (10),
b. at least one micromechanical relief zone (30), within which mechanical stresses in the piezoceramic multilayer actuator (1) can be reduced, while
c. a number of sections (I, II, III) of the piezoceramic multilayer actuator (1) without a micromechanical relief zone (30) have an insulation layer (40; 50), so that the section (I, II, III) of the piezoceramic multilayer actuator (1) is electrically, chemically and/or thermally insulated from a medium surrounding the piezoceramic multilayer actuator (1),
wherein
the insulation layer (40; 50) only extends over sections (I, II, III) of the piezoceramic multilayer actuator (1) without a micromechanical relief zone (30).

2. Piezoceramic multilayer actuator (1) according to claim 1, wherein the insulation layer (40) is a passivation layer, which can be applied before a multilayer actuator green body is sintered or the piezoceramic multilayer actuator (1) is heat-treated.

3. Piezoceramic multilayer actuator (1) according to claim 3, the insulation layer (40) of which consists of glass, ceramic or a sinterable material, the extensibility and/or thermal expansion coefficient of which corresponds approximately to that of the piezoceramic multilayer actuator (1).

4. Piezoceramic multilayer actuator (1) according to claim 1, wherein the insulation layer (40) is a passivation layer, which can be applied after the piezoceramic multilayer actuator (1) has been sintered.

5. Piezoceramic multilayer actuator (1) according to claim 4, the insulation layer (40) of which consists of a plastic or polymer.

6. Piezoceramic multilayer actuator (1) according to claim 1 or 2, having a piezoelectrically inactive region (50) adjacent to a surrounding medium to form the insulation layer.

7. Piezoceramic multilayer actuator (1) according to claim 6, wherein the electrodes are each configured with a smaller surface than the piezoceramic layers so that the piezoceramic layers each have a piezoelectrically inactive edge region.

8. Piezoceramic component according to claim 6 or 7, the electrodes (20) of which each have contacting section (22), which reaches an outer edge of a piezoceramic layer (10), so that the electrodes (20) can be contacted electrically from outside the piezoceramic multilayer actuator (1).

9. Production method for a piezoceramic multilayer actuator (1) according to one of claims 1 to 7, having the following steps:
a. provision (A) of a number of piezoceramic green films and application (B) of electrodes to at least one side of the piezoceramic green film,
b. arrangement (C) of the piezoceramic green films with electrodes one above the other in a stacking direction (S) to form a stack and sintering (E) of the stack, while at least one material layer is disposed within the stack, which forms a micromechanical relief zone (30) after sintering, and
c. production (D; F) of an insulation layer (40; 50) adjacent to a medium surrounding the piezoceramic multilayer actuator (1) in sections (I, II, III) of the piezoceramic multilayer actuator (1) without a micromechanical relief zone (30), so that the piezoceramic multilayer actuator (1) is electrically, chemically and/or thermally insulated from the outside.

10. Production method according to claim 9, wherein after sintering in a section (I, II, III) of the piezoceramic multilayer actuator (1) that contains no micromechanical relief zone (30), an insulation layer (40) is applied to an outer surface of the piezoceramic multilayer actuator (1) parallel to the stacking direction (S).

11. Production method according to claim 10, the passivation layer (40) of which consists of plastic or a polymer.

12. Production method according to claim 11, wherein before sintering in a section (I, II, III) of the piezoceramic multilayer actuator (1) that contains no micromechanical relief zone (30) after sintering, a layer, in particular a ceramic-type layer, is applied to an outer surface of the piezoceramic multilayer actuator (1) parallel to the stacking direction (S), from which a passivation layer (40) is formed when the piezoceramic multilayer actuator (1) is sintered or heat-treated.

13. Production method according to claim 12, the passivation layer (40) of which consists of glass, ceramic or a material that has an extension capacity that corresponds approximately to the piezoceramic multilayer actuator (1) and/or thermal expansion coefficients.

14. Production method according to claim 9, wherein the insulation layer (50) is formed by forming inactive regions in a peripheral region of the piezoceramic multilayer actuator (1) parallel to the stacking direction (S), in such a manner that a surface of the electrodes (20) is configured smaller than a surface of the adjacent piezoceramic green films.

## Revendications

1. Actionneur multicouche piézocéramique (1) présentant les caractéristiques suivantes :
a. une pluralité de couches piézocéramiques (10) et une pluralité d'électrodes (20), disposées les unes sur les autres selon un sens d'empilement (S), de telle sorte que les électrodes (20) se trouvent sur des côtés opposés des couches piézocéramiques (10),
b. au moins une zone de décharge micromécanique (30) à l'intérieur de laquelle des contraintes mécaniques dans l'actionneur multicouche piézocéramique (1) sont réductibles, tandis que
c. une pluralité de parties (I, II, III) de l'actionneur multicouche piézocéramique (1) sans zone de décharge micromécanique (30) présente une couche d'isolation (40 ; 50), de telle sorte que la partie (1, II, III) de l'actionneur multicouche piézocéramique (1) est isolée électriquement, chimiquement et/ou thermiquement contre un milieu entourant l'actionneur multicouche piézocéramique (1),
ladite couche d'isolation (40 ; 50) s'étendant uniquement sur les parties (I, II, III) de l'actionneur multicouche piézocéramique (1) sans zone de décharge micromécanique (30).

2. Actionneur multicouche piézocéramique (1) selon la revendication 1, dans lequel la couche d'isolation (40) est une couche de passivation qui peut être déposée avant une opération de frittage d'un corps vert d'actionneur multicouche ou un traitement thermique de l'actionneur multicouche piézocéramique (1).

3. Actionneur multicouche piézocéramique (1) selon la revendication 3, dont la couche d'isolation (40) est constituée de verre, de céramique ou d'un matériau frittable dont la capacité d'expansion et/ou le coefficient de dilatation thermique correspond approximativement à celle/celui de l'actionneur multicouche piézocéramique (1).

4. Actionneur multicouche piézocéramique (1) selon la revendication 1, dans lequel la couche d'isolation (40) est une couche de passivation qui peut être déposée après une opération de frittage de l'actionneur multicouche piézocéramique (1).

5. Actionneur multicouche piézocéramique (1) selon la revendication 4, dont la couche d'isolation (40) est constituée d'une matière plastique ou d'un polymère.

6. Actionneur multicouche piézocéramique (1) selon la revendication 1, qui présente de façon contiguë à un milieu environnant une zone piézoélectriquement inactive (50), qui forme la couche d'isolation.

7. Actionneur multicouche piézocéramique (1) selon la revendication 6, dans lequel la surface de chaque électrode est plus petite que celle des couches piézocéramiques, de telle sorte que les couches piézocéramiques présentent chacune une zone périphérique piézoélectriquement inactive.

8. Composant piézocéramique selon la revendication 6 ou 7, dont les électrodes (20) présentent chacune une partie de mise en contact (22) allant jusqu'au bord extérieur d'une couche piézocéramique (10), de telle sorte que les électrodes peuvent être mises en contact électrique depuis un côté extérieur de l'actionneur multicouche piézocéramique (1).

9. Procédé de fabrication d'un actionneur multicouche piézocéramique (1) selon l'une des revendications 1 à 7, comprenant les étapes suivantes :
a. fournir (A) une pluralité de feuilles vertes piézocéramiques et déposer (B) des électrodes sur au moins une face de la feuille verte piézocéramique,
b. disposer (C) les feuilles vertes piézocéramiques munies d'électrodes selon un sens d'empilement les unes sur les autres pour former un empilement et procéder au frittage (E) de l'empilement, tandis qu'au moins une couche de matériau est disposée à l'intérieur de l'empilement, laquelle forme après le frittage une zone de décharge micromécanique (30), et
c. réaliser (D; F) une couche d'isolation (40; 50) contiguë à un milieu entourant l'actionneur multicouche piézocéramique (1) dans des parties (I, II, III) de l'actionneur multicouche piézocéramique (1) sans zone de décharge micromécanique (30), de telle sorte que l'actionneur multicouche piézocéramique (1) soit isolé électriquement, chimiquement et/ou thermiquement vers l'extérieur.

10. Procédé de fabrication selon la revendication 9, dans lequel on dépose (F) après le frittage, dans une partie (I, II, III) de l'actionneur multicouche piézocéramique (1) ne contenant pas de zone de décharge micromécanique (30), une couche d'isolation (40) sur une surface externe de l'actionneur multicouche piézocéramique (1) parallèlement au sens d'empilement (S).

11. Procédé de fabrication selon la revendication 10, dont la couche de passivation (40) est constituée de matière plastique ou d'un polymère.

12. Procédé de fabrication selon la revendication 11, dans lequel on dépose (D) avant le frittage, dans une partie (I, II, III) de l'actionneur multicouche piézocéramique (1) ne contenant pas de zone de décharge micromécanique (30) après le frittage, une couche, en particulier une couche ressemblant à la céramique, sur une surface externe de l'actionneur multicouche piézocéramique (1) parallèlement au sens d'empilement (S), à partir de laquelle on forme une couche de passivation (40) pendant le frittage ou un traitement thermique de l'actionneur multicouche piézocéramique (1).

13. Procédé de fabrication selon la revendication 12, dont la couche de passivation (40) est constituée de verre, de céramique ou d'un matériau présentant une capacité d'expansion et/ou un coefficient de dilatation thermique correspondant approximativement à l'actionneur multicouche piézocéramique (1).

14. Procédé de fabrication selon la revendication 9, dans lequel on forme la couche d'isolation (50) par formation de zones inactives dans une zone périphérique de l'actionneur multicouche piézocéramique (1) parallèlement au sens d'empilement de telle façon qu'une surface des électrodes (20) soit plus petite par rapport à une surface des feuilles vertes piézocéramiques contiguës.
